**Europäisches Patentamt**

**European Patent Office**

**Office européen des brevets**

(11) Veröffentlichungsnummer: **0 323 582**
**A1**

## (12) EUROPÄISCHE PATENTANMELDUNG

(21) Anmeldenummer: **88120680.9**

(22) Anmeldetag: **10.12.88**

(51) Int. Cl.4: **B32B 18/00 , H01L 39/12 , H01L 39/24 , C04B 35/00**

(30) Priorität: **24.12.87 DE 3744144**

(43) Veröffentlichungstag der Anmeldung:
**12.07.89 Patentblatt 89/28**

(84) Benannte Vertragsstaaten:
**CH DE FR LI SE**

(71) Anmelder: **Asea Brown Boveri**
**Aktiengesellschaft**
**Kallstadter Strasse 1**
**D-6800 Mannheim 31(DE)**

(72) Erfinder: **Rohr, Franz-Josef, Dr.**
**Physiko-Chemiker**
**Forstweg 2**
**D-6941 Absteinach(DE)**
Erfinder: **Reich, Andreas**
**Alstatter Strasse 55**
**D-6900 Heidelberg(DE)**
Erfinder: **Speil, Peter, Dipl.-Ing.**
**Greifstrasse 25**
**D-6900 Heidelberg(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**D-6800 Mannheim 1(DE)**

(54) **Supraleiter und Verfahren zu seiner Herstellung.**

(57) Die Erfindung bezieht sich auf ein Verfahren zur Herstellung eines Supraleiters (1) aus einem oxidkeramischen Werkstoff, der auf einen Träger (5) aufgetragen ist. Erfindungsgemäß wird aus Yttriumoxid, Kupferoxid, Bariumperoxid oder Bariumkarbonat ein Pulver hergestellt und dieses Pulver nach Korngrößen getrennt. Anschließend werden auf den Träger (5) vorzugsweise zwei oder drei Schichten (2,3,4) aus diesem oxidkeramischen Pulver aufgetragen, wobei zur Ausbildung jeder Schicht (2,3,4) Pulver mit einer definierten Korngröße verwendet wird. Das Auftragen der Schichten (2,3,4) erfolgt durch Plasmaspritzen, wobei dem Trägergas Sauerstoff beigemischt wird. Die Menge des Sauerstoffs richtete sich nach der Korngröße des Pulvers. Anschließend wird der Supraleiter (1) einer Temperaturbehandlung unterzogen.

Fig.1

## Supraleiter und Verfahren zu seiner Herstellung

Die Erfindung bezieht sich auf ein Verfahren zur Herstellung eines Supraleiters gemäß dem Oberbegriff des Patentanspruches 1 sowie auf einen nach diesem Verfahren hergestellten Supraleiter.

Solche Supraleiter kommen vor allem in der Energietechnik zur Anwendung. Sie sind für die Weiterentwicklung im Bereich der Kernfusion, der supraleitenden Generatoren sowie für den Bau von Starkfeldmagneten erforderlich. Die Supraleiter werden vorzugsweise als Fasern, Bänder, Folien, Rohre, Körper mit Kapillarstruktur oder Körper mit Wabenstruktur bzw. in Form von Platten ausgebildet. Seit längerem werden Supraleiter aus Metallen der D-Metall-Reihe und aus Metallen, die am Anfang der P-Reihe stehen, hergestellt. Seit kurzem ist es auch möglich, Supraleiter aus keramischen Werkstoffen herzustellen. Es handelt sich dabei um oxidkeramische Materialien mit Perowskitstruktur, die supraleitende Eigenschaften aufweisen. Diese oxidkeramischen Werkstoffe werden auf einem metallischen oder nichtmetallischen Träger aufgetragen, der eine definierte mechanische Festigkeit und eine ausreichende Flexibilität aufweist. Bisher wurde bevorzugt Strontiumtitanat ($SrTiO_3$) für die Herstellung des Trägers verwendet. Der zur Ausbildung der supraleitenden Schicht verwendete oxidkeramische Werkstoff wird bei den bekannten Supraleitern durch epitaktische Abscheidung aus der Gasphase bzw. durch Plasmaspritzen auf den Träger aufgebracht.

Ein Nachteil der neuen oxidkeramischen Werkstoffe mit surpaleitenden Eigenschaften besteht darin, daß sie direkt nur schwer zu elektrischen Leitern in Form von Drähten, Fasern, Schichten verarbeitet werden können, ohne daß dabei ihre supraleitenden Eigenschaften verlorengehen.

Der Erfindung liegt deshalb die Aufgabe zugrunde, ein Verfahren aufzuzeigen, mit dem ein Supraleiter so hergestellt werden kann, daß die supraleitenden Eigenschaften des für die Herstellung verwendeten oxidkeramischen Materials auch nach der Fertigstellung vollständig vorhanden sind.

Diese Aufgabe wird erfindungsgemäß durch die Merkmale des Patentanspruches 1 gelöst.

Erfindungsgemäß wird das supraleitende Material in Form von einer oder mehreren Schichten auf einen Träger aufgebracht, der aus einem metallischen oder nichtmetallischen Material hergestellt ist. Der Träger kann aus Metall, Metallegierungen, Metalloxiden, Metallcarbiden, Metallnitriden, Metallboriden oder Silikaten gefertigt werden. Die supraleitenden Schichten werden mit Hilfe des Plasmaspritzverfahrens auf die Oberfläche des Trägers

aufgebracht. Vorzugsweise werden drei Schichten übereinander angeordnet. Zur Ausbildung der Schichten wird das oxidkeramische Material in Pulverform verwendet. Zur Herstellung des Pulvers werden Yttriumoxid, Bariumperoxid und Kupferoxid bzw. Yttriumoxid, Bariumcarbonat und Kupferoxid auf eine Temperatur von 930 °C bis 950 °C erhitzt, daraufhin in Sauerstoff abgekühlt und bei 400 °C bis 500 °C getempert. Anschließend wird das so gewonnene Sintermaterial gemahlen. Das gewonnene Pulver wird durch fraktioniertes Sieben nach Korngrößen sortiert, und zwar werden Korngrößen kleiner als 32 µm, Korngrößen zwischen 32 und 63 µm, Korngrößen zwischen 63 und 125 µm, sowie Korngrößen zwischen 125 und 250 µm voneinander getrennt. Die auf den Träger aufzutragenden Schichten werden mit diesem Pulver ausgebildet, wobei für jede Schicht ein Pulver mit einer anderen Korngröße verwendet wird. Die auf den Träger direkt aufzutragende Schicht wird durch ein grobes Pulver gebildet. Für die nachfolgenden Schichten werden immer feinere Korngrößen verwendet. Für das Plasmaspritzen wird als Trägergas ein inertes Gas, bspw. Argon verwendet, dem Sauerstoff beigemischt ist. Die Menge des beizumischenden Sauerstoffes richtet sich nach der Korngröße des Pulvers. Ist die Korngröße groß, so ist die Sauerstoffkonzentration des Trägergases relativ niedrig. Bei der ersten Schicht, die auf den Träger aufgebracht wird, ist die Sauerstoffkonzentration kleiner als 15 % bezogen auf die Gesamtmenge des verwendeten Trägergases. Für die Ausbildung der zweiten Schicht, die auf die erste aufgetragen wird, wird ein Pulver mit mittelgroßer Korngröße verwendet. Vorzugsweise beträgt die Korngröße 63 bis 125 µm. Es kann jedoch auch eine Pulvermischung verwendet werden, bei der die Korngröße zwischen 32 und 250 µm liegt. Die Sauerstoffkonzentration des Trägergases liegt zwischen 15 und 25 % bezogen auf die Gesamtmenge des verwendeten Trägergases gewählt. Wird auf die beiden Schichten eine dritte aufgetragen, so wird hierfür ein feinkörniges Pulver vewendet, dessen Korngröße vorzugsweise zwischen 32 bis 63 µm liegt. Es kann auch eine Pulvermischung verwendet werden, die Korngrößen aufweist, die kleiner als 32 µm und die 32 bis 63 µm groß sind. Der Sauerstoffanteil des Trägergases beträgt in diesem Fall 25 bis 35 % bezogen auf die Gesamtmenge des verwendeten Trägergases.

Wird als Träger ein Material verwendet, das bei der Einwirkung von hohen oder tiefen Temperaturen mit dem supraleitenden Material reagiert, bzw. eine sonstige chemische Verbindung mit dem supraleitenden Material eingeht, so muß auf den Träger vor dem Aufbringen der ersten Schicht eine Zwischenschicht aus einem Mischoxid mit Perovskitstruktur aufgetragen werden. Auch diese Zwischenschicht wird durch Plasmaspritzen auf den Träger aufgebracht. Es hat sich gezeigt, daß es von Vorteil ist, wenn der Träger bei der Herstellung des Supraleiters, insbesondere beim Auftragen der Schichten auf einer konstanten Temperatur gehalten wird. Vorzugsweise wird der Träger mit Hilfe einer Kühl- oder Heizeinrichtung auf einer Temperatur von 400 bis 500 °C gehalten. Bei einer guten Verträglichkeit zwischen dem supraleitenden Material und dem Trägermaterial kann anstelle von mehreren Schichten auch nur eine dicke Schicht aus supraleitendem Material auf den Träger aufgebracht werden. Eine Vielzahl von dünnen Schichten ist dann sinnvoll, wenn die Haftfestigkeit einer einzigen dicken Schicht nicht gewährleistet ist. Um sicherzustellen, daß nach der Fertigung des Supraleiters seine supraleitenden Eigenschaften, die beim Auftragen der Schichten möglicherweise verlorengegangen sind, wieder hergestellt werden, wird der gesamte Supraleiter an der Luft ca. 0,5 bis 1 Stunde auf eine Temperatur zwischen 750 °C und 950 °C erwärmt und anschließend mit einer Abkühltemperatur von 1 °C bis 3 °C pro Minute in einer Sauerstoffatmosphäre auf 400 °C bis 500 °C abgekühlt. Der Supraleiter wird mehrere Stunden auf dieser Temperatur gehalten und dann ebenfalls mit einer Abkühltemperatur von 1 °C bis 3 °C pro Minute auf Raumtemperatur abgekühlt.

Weitere erfindungswesentliche Merkmale sind in den Unteransprüchen gekennzeichnet. Der Supraleiter wird nachfolgend anhand von Zeichnungen erläutert.

Es zeigen:

Figur 1: einen Supraleiter,

Figur 2: eine Variante des in Figur 1 dargestellten Supraleiters.

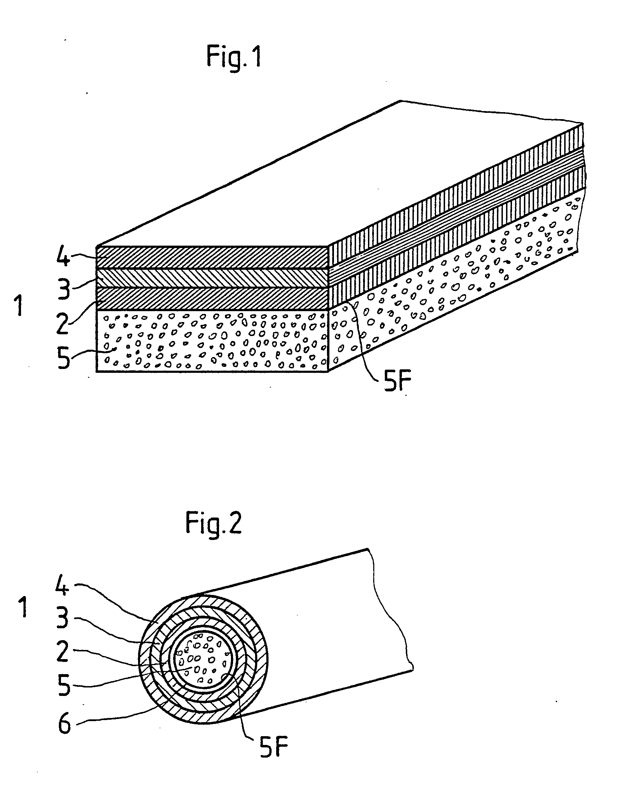

Der in Figur 1 gezeigte Supraleiter 1 wird im wesentlichen durch drei Schichten 2,3,4 und einen Träger 5 gebildet. Zur Ausbildung der Schichten 2,3 und 4 wird zunächst ein Pulver der supraleitenden Verbindung $YBa_2Cu_3O_{7-x}$ aus Yttriumoxid, Bariumoxid und Kupferoxid bzw. Yttriumoxid, Bariumcarbonat und Kupferoxid hergestellt. Hierzu wird das oben genannte Ausgangsmaterial auf 930 bis 950 °C erwärmt und drei bis vier Stunden auf dieser Temperatur gehalten und dann langsam in Sauerstoff auf 400 bis 500 °C abgekühlt und bei dieser Temperatur in Sauerstoff getempert. Anschließend wird der so gewonnene Sinterkuchen in einer geeigneten Mühle, bspw. einer Kugel-, Planeten- oder Schwingmühle gemahlen. Das hierbei hergestellte Pulver wird mit Hilfe von Sieben nach bestimmten Korngrößen sortiert.

Für die Herstellung der supraleitenden Schichten ist ein Pulver mit einer Korngröße kleiner/gleich 32 $\mu$m, sowie ein Pulver mit einer Korngröße zwischen 32 und 62 $\mu$m, ein Pulver mit einer Korngröße zwischen 63 und 125 $\mu$m und ein Pulver mit einer Korngröße von 125 bis 250 $\mu$m erforderlich. Das Auftragen der Schichten 2,3,4 erfolgt mit Hilfe des bekannten Plasmaspritzverfahrens. Als Trägergas wird Argon verwendet, dem vor dem Austritt aus der Spritzpistole Sauerstoff beigemischt wird. Die Sauerstoffkonzentration des Trägergases richtet sich nach der verwendeten Korngröße des Pulvers. Zur Ausbildung des Trägers 5 wird vorzugsweise ein Material verwendet, das sowohl thermisch als auch chemisch mit dem supraleitenden Material verträglich ist. Hierfür sind vor allem metallische, nichtmetallische oder keramische Werkstoffe oder metallische Legierungen geeignet. Vorzugweise werden für die Fertigung des Trägers 5 Liegierungen auf der Basis von Nickel und Chrom, Oxide oder Mischoxide wie $Al_2O_3$, $Zr_2/Y_2O_3$, $MgAl_2O_4$, bzw. Metallcarbide, Silikate oder Cordierit verwendet. Alle diese Werkstoffe gewährleisten eine beständige Haftfestigkeit des supraleitenden Materials auf der Oberfläche des jeweiligen Trägers. Ferner wird bei Verwendung dieser Werkstoffe sichergestellt, daß keine chemischen Reaktionen zwischen dem Trägermaterial und dem supraleitenden Werkstoff stattfindet. Wird der Träger 5 aus einem der oben genannten Werkstoffe hergestellt, so wird heirdurch die notwendige mechanische Stabilität für den Supraleiter erzielt. Der hier verwendete Träger 5 hat die Form eines Bandes oder Blattes und weist eine Dicke von 5 mm auf. Seine Abmessungen sind frei wählbar ist. Auf seine Oberfläche 5F ist eine erste supraleitende Schicht 2 aufgetragen. Für die Ausbildung dieser Schicht 2 wird Pulver verwendet, dessen Herstellung oben beschrieben ist. Das verwendete Pulver weist eine Korngröße zwischen 125 und 250 $\mu$m auf. Die Dicke der aufgetragenen Schicht 2 beträgt 30 bis 100 $\mu$m. Das Auftragen erfolgt mittels Plasmaspritzen wobei als Trägergas Argon verwendet wird, dem Sauerstoff beigemischt ist. Die Sauerstoffkonzentration des Trägergases ist kleiner/gleich 15 % bezogen auf die Gesamtmenge des verwendeten Trägergases. Auf die Oberfläche der ersten Schicht 2 wird unmittelbar eine zweite Schicht 3 aufgetragen. Hierfür wird Pulver verwendet, das eine Korngröße zwischen 63 und 125 $\mu$m aufweist. Zur Ausbildung der Schicht 3 kann auch eine Mischung aus dem o.g. Pulver verwendet werden, die dann Korngrößen zwischen 32 und 250 $\mu$m aufweist. Die gewählte Sauerstoffkonzentration des Trägergases liegt zwischen 15 und 25 % bezogen auf die Gesamtmenge des verwendeten Argongases. Die Dicke der Schicht 3 beträgt 20 bis 50 $\mu$m.

Auf diese Schicht 3 wird vorzugsweise eine dritte Schicht 4 aufgetragen. Diese weist auch eine Dicke von 20 bis 50 μm auf. Für die Ausbildung der dritten Schicht 4 wird ein Pulver verwendet, das eine Korngröße zwischen 32 und 63 μm aufweist. Zur Ausbildung der Schicht 4 kann 2 auch eine Mischung des Pulvers verwendet werden, wobei Pulver der oben beschriebenen Art mit einer Korngröße kleiner/gleich 32 μm mit Pulver gemischt wird, das eine Korngröße zwischen 32 und 63 μm besitzt. Die Sauerstoffkonzentration des Trägergases ist hierbei sehr hoch. Sie beträgt 25 bis 30 % bezogen auf die Menge des verwendeten Trägergases. Gegebenenfalls kann die Sauerstoffkonzentration bei Verwendung eines Pulvers mit noch kleinerer Korngröße bis auf 40 % erhöht werden. Während des Auftragens der Schichten 2,3,4 wird der Träger 5 auf einer Temperatur zwischen 400 bis 500 °C gehalten. Um dies zu ermöglichen, sind entsprechende Heiz- bzw. Kühleinrichtungen (hier nicht dargestellt) vorgesehen, welche die Einhaltung dieser Temperatur sicherstellen. Für die Ausbildung des in Figur 1 dargestellten Supraleiters 1 sind auf die Oberfläche 5F des Trägers 5 drei Schichten 2,3 und 4 übereinander aufgetragen. Falls für die Ausbildung des Trägers 5 ein Werkstoff verwendet wird, der eine sehr gute Haftfestigkeit einer supraleitenden Schicht auf seiner Oberfläche 5F sicherstellt, kann auch anstelle der drei Schichten 2,3,4 nur eine Schicht aus supraleitendem Werkstoff auf die Oberfläche aufgetragen werden. Diese einzelne Schicht 2 wird vorzugsweise 50 bis 200 μm dick aufgetragen. Ist eine nicht allzu dicke Beschichtung mit supraleitendem Material erforderlich, so genügt die Ausbildung von zwei Schichten 2,3. Hierfür wird vorzugsweise ein Pulver verwendet, dessen Korngröße zwischen 32 und 250 μm liegt. Pulver mit dieser Korngröße kann auch dann verwendet werden, wenn auf den Träger 5 nur eine Schicht 2 aufgebracht wird. Nach dem Aufbringen der Schichten auf die Oberfläche des Trägers 5 erfolgt eine Nachbehandlung des Supraleiters 1, mit der sichergestellt wird, daß die bei der Herstellung teilweise oder ganz verlorengegangene supraleitende Eigenschaft wieder hergestellt wird. Zur Nachbehandlung wird der Supraleiter 1 an Luft auf eine Temperatur zwischen 900 °C und 950 °C erhitzt und ca. 0,5 Stunden auf dieser Temperatur gehalten und dann stufenweise abgekühlt. Die Abkühlung erfolgt in einer Sauerstoffatmosphäre, und zwar in Schritten von 1 °C bis 3 °C pro Minute. Die Abkühlung wird solange durchgeführt bis der Supraleiter 1 eine Temperatur von 400 bis 500 °C erreicht hat. Auf dieser Temperatur wird der Supraleiter dann 4 bis 16 Stunden gehalten. Anschließend wird er wiederum mit einer Abkühlgeschwindigkeit von 1 °C bis 3 °C pro Minute abgekühlt, und zwar bis er Raumtemperatur erreicht hat. Beim Erreichen der Raumtemperatur ist die Herstellung des Supraleiters abgeschlossen.

Figur 2 zeigt einen Supraleiter, dessen Träger 5 zylinderförmig ausgebildet ist. Der Träger 5 kann durch einen sehr dünnen Stahlfaden gebildet werden, der beliebig lang ist. Auf seine Oberfläche 5F ist zuerst eine Zwischenschicht 6 aufgetragen. Zur Ausbildung derselben werden keramische oder metallische Werkstoffe verwendet, die geeignet sind, chemische Reaktionen zwischen dem Werkstoff des Trägers und dem supraleitenden Material zu verhindern, und die gleichzeitig sicherstellen, daß das supraleitende Material auf der Oberfläche des Trägers eine beständige Haftung erfährt. Bei dem hier dargestellten Ausführungsbeispiel ist die Zwischenschicht 6 aus einem mit Yttriumoxid dotierten Zirkoniumdioxid hergestellt. Die Verwendung von oxidkeramischen Materialien mit Perowskitstruktur ist ebenfalls möglich. Bei dem in Figur 2 dargestellten Supraleiter ist auf die Zwischenschicht 6, die vorzugsweise eine Dicke von 20 bis 100 μm aufweist, die erste supraleitende Schicht 2 unmittelbar aufgetragen. Auf diese folgen nach außenhin eine zweite und ggf. eine dritte supraleitende Schicht 3,4. Die supraleitenden Schichten 2,3,4 sind in gleicher Weise ausgebildet, wie die in Figur 1 dargestellten und in der zugehörigen Beschreibung erläuterten Schichten 2,3,4.

## Ansprüche

1. Verfahren zur Herstellung eines Supraleiters aus einem oxidkeramischen Werkstoff, der auf einen Träger (5) aufgetragen ist, dadurch gekennzeichnet, daß eine vorzugsweise mehrere Schichten (2,3,4) des oxidkeramischen Werkstoffes übereinander auf den Träger (5) aufgetragen werden, daß der oxidkeramische Werkstoff zur Ausbildung der Schichten (2,3,4) in Form eines Pulvers verwendet wird, das für jede Schicht (2,3,4) eine definierte Korngröße aufweist, und daß die Schichten (2,3,4) anschließend wenigstens einer Temperaturbehandlung unterzogen werden.

2. Verfahren nach Anspruch 1, dadurch gekennzeichnet, daß zur Ausbildung der Schichten (2,3,4) ein oxidkeramisches Pulver mit der Strukturformel $A_xB_yM_zO_n$, hergestellt wird, wobei A für ein seltenes Erdmetall, B für eine Erdalkalimetall und M je ein Übergangsmetall steht, $x = 1$, $y = 2$ und $z = 3$ ist, und n einen Wert zwischen 6,8 und 6,95 aufweist.

3. Verfahren nach einem der Ansprüche 1 oder 2, dadurch gekennzeichnet, daß die Schichten (2,3,4) mittels Plasmaspritzen auf den Träger (5) aufgetragen werden, der aus einem metallischen, nichtmetallischen oder keramischen Werkstoff oder einer metallischen Legierung, vorzugsweise aus einer Legierung auf der Basis von Nickel und Chrom, einem Oxid oder Mischoxid in Form von $Al_2O_3$,

$ZrO_2/Y_2O_3$, $MgAl_2O_4$ bzw. Carbiden oder Silikaten gefertigt wird, und daß für das Plasmaspritzen Argon als Trägergas verwendet wird, dem Sauerstoff in Abhängigkeit von der Korngröße des verwendeten oxidkeramischen Pulvers beigemischt wird.

4. Verfahren nach einem der Ansprüche 1 bis 3, dadurch gekennzeichnet, daß aus Yttriumoxid, Bariumperoxid und Kupferoxid bzw. Yttriumoxid, Bariumkarbonat und Kupferoxid ein oxidkeramisches Pulver mit der Zusammmensetzung $Y_1Ba_2Cu_3O_x$ und mit Korngrößen zwischen kleiner/gleich 32 $\mu$m und 250 $\mu$m zur Ausbildung der Schichten (2,3,4) hergestellt wird, wobei x einen Wert zwischen 6,8 und 6,95 aufweist, daß das Basismaterial hierfür auf 930 bis 950 °C erwärmt und anschließend langsam in einer Sauerstoffatmosphäre auf 400 °C bis 500 °C abgekühlt und zwischen 4 und 16 Stunden auf dieser Temperatur gehalten wird, daß der so gewonnene Sinterkuchen anschließend zur Erzielung eines Pulver mit definierten Korngrößen gemahlen und das Pulver nach Korngrößen getrennt wird.

5. Verfahren nach einem der Ansprüche 1 bis 4, dadurch gekennzeichnet, daß auf der Oberfläche (5F) des Trägers (5) eine Zwischenschicht (6) aus einem keramischen oder metallischen Werkstoff, vorzugsweise aus einem dotierten Zirkoniumdioxid oder einem Mischoxid mit Perowskitstruktur, gebildet wird.

6. Verfahren nach einem der Ansprüche 1 bis 5, dadurch gekennzeichnet, daß zur Ausbildung der ersten, unmittelbar auf den Träger (5) aufzutragenden Schicht (2) ein Pulver mit einer Korngröße zwischen 125 und 250 $\mu$m verwendet wird, und daß die Sauerstoffkonzentration des für das Plasmaspritzen verwendeten Trägergases kleiner/gleich 15 % bezogen auf die Gesamtmenge des verwendeten Trägergases eingestellt wird.

7. Verfahren nach einem der Ansprüche 1 bis 6, dadurch gekennzeichnet, daß zur Ausbildung der zweiten Schicht (3) ein Pulver mit einer Korngröße von 63 bis 125 $\mu$m oder die Mischung eines Pulvers gewählt wird, dessen Korngrößen zwischen 32 und 250 $\mu$m liegen, und daß die Sauerstoffkonzentration des Trägergases zwischen 15 und 25 % bezogen auf die Gesamtmenge des verwendeten Trägergases eingestellt wird.

8. Verfahren nach einem der Ansprüche 1 bis 7, dadurch gekennzeichnet, daß auf die zweite Schicht (3) unmittelbar eine dritte Schicht (4) aufgetragen wird, für deren Herstellung ein Pulver mit einer Korngröße zwischen 32 und 63 $\mu$m bzw. eine Pulvermischung verwendet wird, die eine Korngröße kleiner 32 $\mu$m und eine Korngröße zwischen 32 und 63 $\mu$m aufweist, und daß der Sauerstoffanteil des Trägergases auf 25 bis 40 % bezogen auf die Gesamtmenge des verwendeten Trägergases eingestellt wird.

9. Verfahren nach einem der Ansprüche 1 bis 8, dadurch gekennzeichnet, daß der Träger (5) während der Beschichtung mit dem oxidkeramischen Werkstoff auf einer Temperatur zwischen 400 und 500 °C gehalten wird, daß nach dem Auftragen der Schichten (2,3,4) der Träger (5) mit den Schichten (2,3,4) an Luft auf eine Temperatur von 750 bis 950 °C erhitzt wird, daß daraufhin eine Abkühlung der Schichten (2,3,4) in einer Sauerstoffatmosphäre mit einer Abkühlgeschwindigkeit von 1 °C bis 3 °C pro Minute auf 400 °C bis 500 °C durchgeführt wird, daß die Schichten (2,3,4) und der Träger (5) 4 bis 16 Stunden auf dieser Temperatur gehalten und dann wiederum bis auf Raumtemperatur abgekühlt werden.

## Fig.1

## Fig.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ADVANCED CERAMIC MATERIALS- CERAMIC SUPERCONDUCTORS, Band 2, Nr. 3B, 20. Juli 1987, Special Issue, Seiten 329-336, American Ceramic Society, Westerville, OH, US; M.J. CIMA et al.: "Powder processing for microstructural control in ceramic superconductors" * Seiten 329-331 * | 1-9 | B 32 B 18/00 H 01 L 39/12 H 01 L 39/24 C 04 B 35/00 |
| | --- | | |
| A | US-A-4 629 483 (R.J. STANTON) * Spalte 2, Zeilen 33-54; Figuren 1,2 * | 1-9 | |
| | ----- | | |

**RECHERCHIERTE SACHGEBIETE (Int. Cl.4)**

B 32 B
H 01 L
C 04 B

Der vorliegende Recherchenbericht wurde für alle Patentansprüche erstellt

| Recherchenort | Abschlußdatum der Recherche | Prüfer |
|---|---|---|
| DEN HAAG | 31-03-1989 | LUETHE H. |